(19) Europäisches Patentamt
European Patent Office
Office européen des brevets

(11) **EP 4 675 672 A1**

(12) **EUROPEAN PATENT APPLICATION**

(43) Date of publication:
**07.01.2026 Bulletin 2026/02**

(21) Application number: 25182879.4

(22) Date of filing: **16.06.2025**

(51) International Patent Classification (IPC):
*H01L 21/48* (2006.01)    *H01L 23/367* (2006.01)
*H01L 23/473* (2006.01)    *H01L 23/373* (2006.01)

(52) Cooperative Patent Classification (CPC):
**H01L 21/4871; H01L 23/367; H01L 23/3733;
H01L 23/473**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **25.06.2024 GB 202409059**

(71) Applicant: **Rolls-Royce plc
London N1 9FX (GB)**

(72) Inventor: **Shahpar, Shahrokh
Derby, DE24 8BJ (GB)**

(74) Representative: **Rolls-Royce plc
P.O. Box 31
IP Department (SinA-48)
Derby Derbyshire DE24 8BJ (GB)**

(54) **COLD PLATE**

(57)    A cold plate (101) for transferring heat from a device to a liquid coolant is shown. The cold plate comprises a plurality of coolant flow channels extending from a common inlet (106) to a common outlet (107). The plurality of coolant flow channels is defined by a triply periodic minimal surface comprising a plurality of cells. Each one of the plurality of cells has an associated set of geometric parameters that are dependent upon the disposition of the cell in relation to the common inlet and the common outlet to produce a non-uniform lattice structure.

FIG. 4B

Processed by Luminess, 75001 PARIS (FR)

Description

CROSS-REFERENCE TO RELATED APPLICATIONS

This application claims priority to United Kingdom Patent Application No 2409059.9, filed June 25, 2024, the whole contents of which are incorporated herein by reference in their entirety.

FIELD

This disclosure relates to cold plates, as are typically used for transferring heat from a device to a liquid.

BACKGROUND

Heat-generating devices, for example electronic components, require some form of cooling arrangement to ensure satisfactory performance. In some circumstances, heat may be removed by convection to ambient air by flowing air over a finned heatsink, for example. Alternatively, cold plates may be used to transfer heat to a liquid coolant pumped through the cold plate, the cold plate being arranged in thermal contact with the device. Although such liquid-cooled arrangements are inherently heavier than air-cooled arrangements, they are able to remove a greater quantity of heat.

SUMMARY

In an aspect, there is provided a cold plate for transferring heat from a device to a liquid coolant, the cold plate comprising a plurality of coolant flow channels extending from a common inlet to a common outlet;

wherein the plurality of coolant flow channels is defined by a triply periodic minimal surface comprising a plurality of cells;
wherein each one of the plurality of cells has an associated set of geometric parameters that are dependent upon the disposition of the cell in relation to the common inlet and the common outlet to produce a non-uniform lattice structure.

In an embodiment, the non-uniform lattice structure is configured to spatially vary the flow resistance of the coolant flow channels, thereby directing coolant and encouraging cold plate temperature uniformity.
In an embodiment, the set of geometric parameters comprise cell aspect ratio and cell wall thickness.
In an embodiment, the cell aspect ratio is from 1 to 1.4 and the cell wall thickness is from 0.3 to 4 millimetres.
In an embodiment, the triply periodic minimal surface is a gyroid.
In an embodiment, the cold plate has a polygonal base and a plurality of sides, and the common inlet and the common outlet are located on a common one of the plurality of sides of the cold plate.
In an embodiment, the cold plate comprises an aluminium alloy.
In an embodiment, the cold plate is formed by an additive manufacturing process.
In an embodiment, the cold plate is formed by a vacuum investment casting process.
There is also provided an arrangement comprising a device and a cold plate of the aforesaid type for transferring heat from a device to a liquid coolant.
In an embodiment, the device comprises a plurality of electrical power conversion devices.
In another aspect, there is provided a computer-implemented method of designing a cold plate for transferring heat from a device to a coolant, comprising:

obtaining the heat source characteristics of the device;
initialising a cold plate geometry, the cold plate geometry comprising a plurality of coolant flow channels extending from a common inlet to a common outlet, wherein the plurality of coolant flow channels is defined by a triply periodic minimal surface comprising a plurality of cells, and wherein each one of the plurality of cells has an associated set of geometric parameters that are dependent upon the disposition of the cell in relation to the common inlet and the common outlet;
establishing one or more control points within the cold plate geometry, wherein each one of the set of geometric parameters of the plurality of cells is controlled by one of a plurality of control points;
evaluating the heat transfer and total pressure loss characteristics of the cold plate geometry based on the heat source characteristics of the device;
performing one or more optimisation loops comprising adjusting the one or more control points to produce an adjusted cold plate geometry, and evaluating the heat transfer and total pressure loss characteristics of the adjusted cold plate geometry.

In an embodiment, the control points are comprised within a radial basis function.

In an embodiment, the control points are adjusted by performing a perturbation of the radial basis function at one or more of its control points.

In an embodiment, the heat transfer and total pressure loss characteristics of the cold plate geometry are evaluated using a conjugate heat transfer simulation. In an embodiment the conjugate heat transfer simulation is a Reynolds-averaged Navier-Stokes (RANS) type simulation.

In an embodiment, the optimisation loops are performed until no further change in heat transfer and total pressure loss characteristics are achieved..

**BRIEF DESCRIPTION OF THE DRAWINGS**

Embodiments will now be described by way of example only with reference to the accompanying drawings, in which:

FIG. 1 is an isometric, blown-apart view of an arrangement comprising a device and a cold plate for transferring heat from a device to a liquid coolant;

FIG. 2 shows the general path that the liquid coolant follows through the cold plate of FIG. 1;

FIG. 3A is a cross section through the X-Y plane of the cold plate prior to optimisation of the geometric parameters;

FIG. 3B shows an example triply periodic minimal surface;

FIG. 4A shows exemplary locations for control points for controlling the set of geometric parameters of FIG. 3A;

FIG. 4B is a cross section through the X-Y plane of the cold plate of FIG. 4A after optimisation of the geometric parameters;

FIG. 5 shows the procedure for optimising the geometric parameters;

FIG. 6A shows temperature contours in a cold plate having a serpentine coolant channel;

FIG. 6B shows temperature contours in the cold plate of FIG. 3A;

FIG. 6C shows temperature contours in the cold plate of FIG. 4B.

**DETAILED DESCRIPTION**

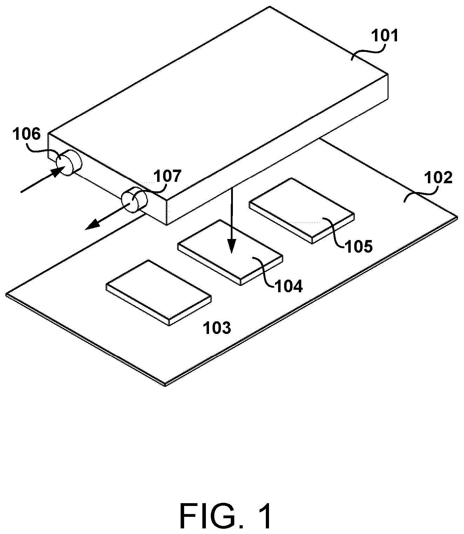

An arrangement comprising a cold plate 101 for transferring heat from a device 102 to a liquid coolant is shown in Figure 1. In this example, the device 102 is an electrical converter, and comprises a plurality of electrical power conversion devices 103, 104 and 105. In this example, the electrical power conversion devices 103, 104 and 105 are semiconductor power conversion devices, for example JFETs, power MOSFETs, IGBTs, etc. Hence, in operation, the device 102 may be configured to operate as a rectifier (DC-to-AC), an inverter (AC-to-DC) or a voltage converter (DC-to-DC).

It will be appreciated that in such applications, the electrical power conversion devices 103, 104 and 105 will generate a substantial quantity of excess heat due to switching losses, which occur when the devices transition from blocking to conducting states and back again. In order to ensure reliable operation of the device 102, the temperatures of the electrical power conversion devices 103, 104 and 105 should be ideally kept within a certain operating range, and as uniform as possible. It will be appreciated that in alternative implementations, the device 102 could be another type of electronic device, for example a microprocessor, an imaging sensor or a laser diode, or any other form of heat-generating device.

In the present example, the cold plate 101 is positioned into thermal contact with the electrical power conversion devices 103, 104 and 105. It will be appreciated that in some instances a thermal pad, thermal paste or the like may be added at the interface between the cold plate and the devices. The cold plate 101 is formed of a thermally conductive material. In a specific embodiment, the cold plate 101 is formed of aluminium or an aluminium alloy. Alternatively, the cold plate could be formed of copper or any other suitable thermally conductive material or alloy.

In operation, the cold plate 101 admits liquid coolant at an inlet 106, which then flows through coolant flow channels inside the cold plate 102 and absorbs the heat generated by the electrical power conversion devices 103, 104 and 105 and conducted into the cold plate 102. The liquid coolant exits the cold plate 101 at an outlet 107 whereupon it may be pumped to another heatsink such as a radiator to reject the heat to atmosphere, for example. It will be appreciated that the liquid coolant could comprise water, a glycol mixture, etc. and that the selection of the appropriate fluid will depend on the operational environment.

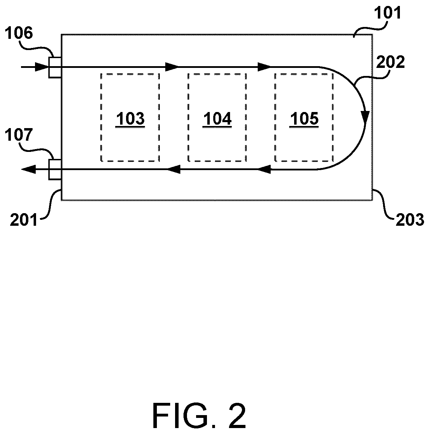

The general path that the liquid coolant follows through the cold plate 101 is shown in Figure 2. In the present embodiment, the base of the cold plate 101 has a polygonal shape and the inlet 106 and outlet 107 are located on a common side 201 of the cold plate 101. This is a common arrangement as it tends to simplify the routing of pipes for the liquid coolant. In this specific embodiment the cold plate 101 is rectangular so as to cover the three electrical power conversion devices 103, 104 and 105, however it will be appreciated that in other embodiments the base of the cold plate 102 could adopt any other suitable shape depending upon the topology of the device 102 and the location of the heat sources. For example, the base could be a regular, rectilinear, convex or concave polygon, or the base could alternatively be curved, forming, for example, a cylinder.

Referring again to Figure 2, with the inlet 106 and outlet 107 being positioned on the same side, the liquid coolant follows a generally "U" shaped path 202 from the side 201, across the planar extent of the cold plate 101 to the opposite side 203, and back again.

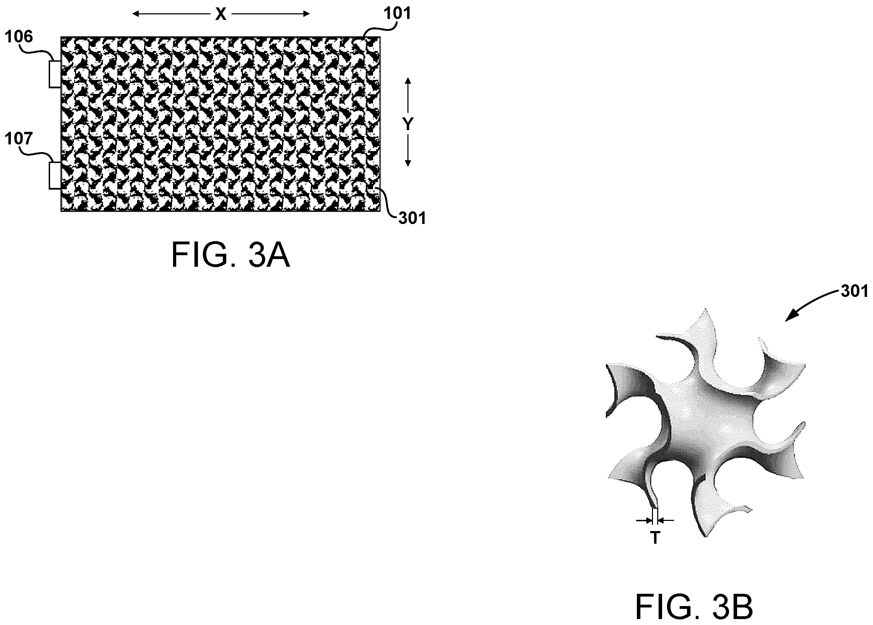

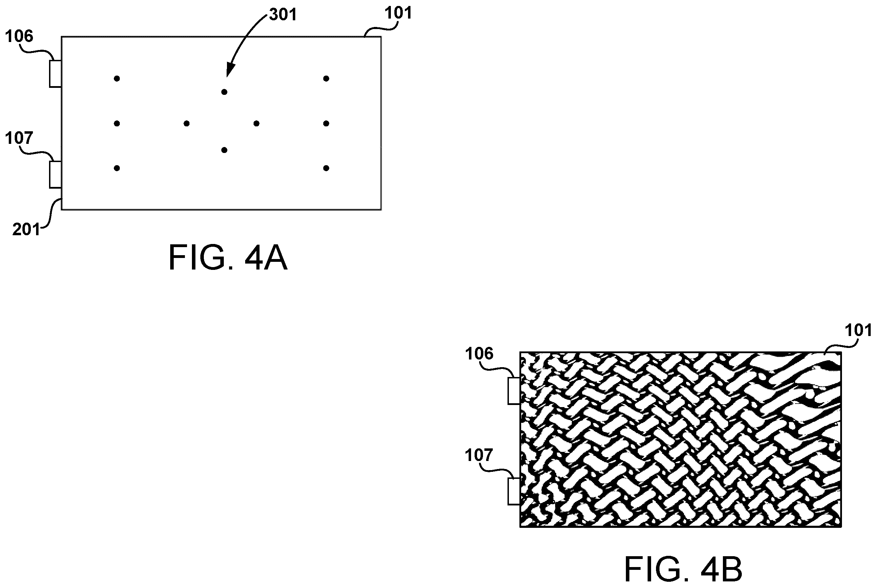

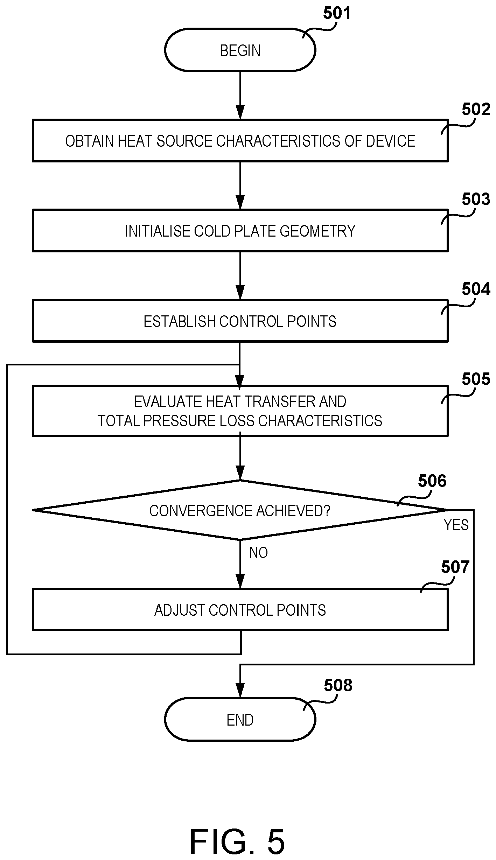

However, unlike typical cold plates which utilise a serpentine path for the cooling fluid, for example, the cold plate 101 utilises a plurality of coolant flow channels extending from the inlet 106 to the outlet 107, which are common to the coolant flow channels. The coolant flow channels are defined by a triply-period minimal surface. This configuration will be described further with reference to Figure 3A and Figure 3B. An optimisation of the internal geometric configuration of the cold plate 101 may be performed so as to maximise the effectiveness of the cold plate - this optimisation procedure will be described further with reference to Figure 4A, Figure 4B and Figure 5,

A cross sectional view of the cold plate 101 is shown in Figure 3A prior to carrying out any optimisation. In this state, the coolant flow channels, are defined by a triply periodic minimal surface which comprises a plurality of cells 301. In this way, the internal structure forms a type of lattice, with cooling fluid able to flow through parallel coolant flow channels. Each of these cells has an associate set of geometric parameters. Prior to optimisation, all of the cells have the same geometric parameters, however post optimisation each cell adopts a set of geometric parameters that are dependent upon the disposition of the cell in relation to the inlet 106 and the outlet 107. This produces a non-uniform lattice structure in which the flow resistance of the coolant flow channels may be varied so as to control the flow of coolant therethrough.

Triply periodic minimal surfaces have recently been investigated for use in heat exchange applications due to their high surface area to volume ratio. In the present embodiment, the triply periodic minimal surface inside the cold plate 101 is a gyroid, which is a surface that has three-fold rotational symmetry but no embedded straight lines or mirror symmetries. The gyroid cell 301 is shown in Figure 3B. The surface of the gyroid cell 301 may be approximated trigonometrically:

$$\sin x \cos y + \sin y \cos z + \sin z \cos x = 0 \qquad \text{[Equation 1]}$$

It is contemplated that in alternative embodiments, the triply periodic minimal surface could be a Schwarz P or Schwarz D surface.

In the present embodiment, the set of geometric parameters of each cell 301 comprises the cell aspect ratio and the cell wall thickness. Referring to Figure 3A, the cell aspect ratio is the ratio of the cell's size in the X dimension to its size in the Y dimension. In an embodiment, the aspect ratio may be from 1 to 1.4. Referring to Figure 4A, in an embodiment the cell wall thickness T may be from 0.3 to 4 millimetres. It will be appreciated that in other applications these parameters may differ due to the overall size of the cold plate, size and number of devices, coolant type, etc.

As described previously, the set of geometric parameters associated with each cell depend upon the disposition of the cell in relation to the inlet 106 and the outlet 107. As shown in Figure 4A, in the present embodiment, this is achieved by defining a radial basis function over the cold plate 101 via a plurality of control points 401. By changing the radial basis function at each control point, a new geometry may be obtained, as shown in Figure 4B. Compared to Figure 3A, it will be seen that the cells of the triply periodic minimal surface remain closely packed in the vicinity of the inlet 106 and the outlet 107 which encourages high flow rate, but exhibit significant elongation of their aspect ratio as the liquid coolant flows towards the opposite side 203. Further, it will be noted that there is an asymmetry in the Y direction in Figure 4A, which encourages flow turning to follow the general "U" shaped path of Figure 2. Channel resistance is also controlled via the cell wall thickness so as to encourage a more uniform distribution of liquid coolant through the cooling channels, thereby encouraging temperature uniformity of the cold plate 101.

The optimisation procedure is shown in the form of a flowchart in Figure 5. This procedure may be performed using a computer, for example by loading computer-readable instructions from a computer-readable medium, loading them into memory, and executing them on a processor.

The procedure begins, 501, and at step 502 a set of heat source characteristics of a device are obtained and loaded into memory. In the present example, the heat source characteristics would comprise the size and shape of the device(s), heat flux, etc.

At step 503, a cold plate geometry is initialised. The initial geometry is for a cold plate of an appropriate size and shape and inlet-outlet arrangement for the intended application. Such an example was described with reference to Figure 3A, i.e. geometry with each cell's set of geometric parameters being set to the same values.

At step 504, the control points for the radial basis function are established to control each of the set of geometric parameters. The control points are distributed across the cold plate geometry. The control points provide for a smooth distribution of the geometric parameters in the X and Y directions.

An optimisation loop is then entered, with the heat transfer and total pressure loss characteristics of the cold plate geometry being evaluated at step 505, based on the heat source characteristics obtained at step 502. In an embodiment, the heat transfer and total pressure loss characteristics are evaluated using a conjugate heat transfer simulation. In a specific embodiment, the simulation is a Reynolds-averaged Navier-Stokes (RANS) type simulation.

At step 506, a question is asked as to whether a desired level of convergence of the optimisation loop has been achieved. If answered in the negative, then control proceeds to step 507 where the control points are adjusted, effecting an adjustment of the cold plate geometry by perturbation of the radial basis function. In an embodiment, an optimizer may be used to control the adjustment of control points. The optimizer may employ a genetic algorithm or any other suitable method.

The adjusted geometry is then evaluated again at step 505. This loop is followed until the question asked at step 506 is answered in the affirmative and the procedures ends, 508.. In an embodiment, the desired level of convergence is achieved when no further change in heat transfer and total pressure loss characteristics is achieved. It will be appreciated that other thresholds may be set, for example number of loops executed, processing time, reaching a threshold cold plate effectiveness or other performance objective, etc.

After the procedure ends, the final geometry may be output for manufacture, for example by an additive manufacturing process, such as selective laser sintering.

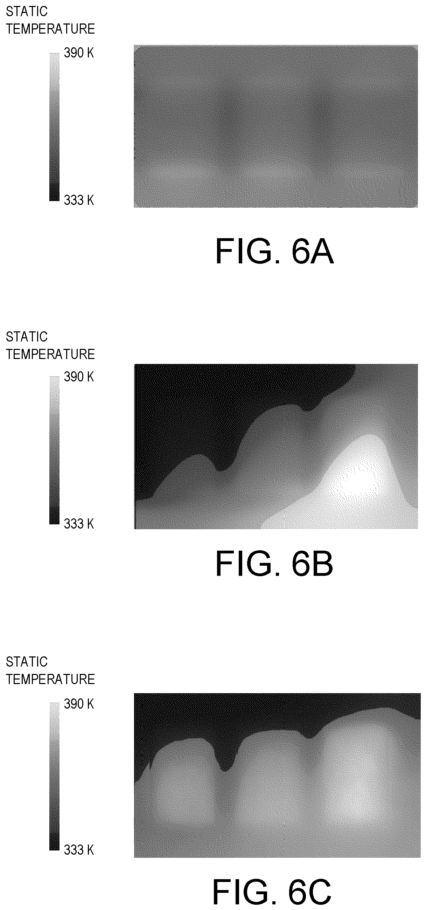

A comparison of cold plate temperatures is shown in Figures 6A, 6B and 6C. Figure 6A shows the temperature distribution of a cold plate having a serpentine coolant flow channel. Figure 6B shows the temperature distribution of the cold plate 101 prior to optimisation, i.e. as shown in Figure 3A. Figure 6C shows the temperature distribution of the cold plate 101 after optimisation, i.e. as shown in Figure 4B; it may be seen that the non-uniform lattice structure and resultant spatial variance in flow resistance of the coolant flow channels results in improved cold plate temperature uniformity.

Various examples have been described, each of which comprise one or more combinations of features. It will be appreciated by those skilled in the art that, except where clearly mutually exclusive, any of the features may be employed separately or in combination with any other features and the invention extends to and includes all combinations and sub-combinations of one or more features described herein.

## Claims

1. A cold plate for transferring heat from a device to a liquid coolant, the cold plate comprising a plurality of coolant flow channels extending from a common inlet to a common outlet;

   wherein the plurality of coolant flow channels is defined by a triply periodic minimal surface comprising a plurality of cells;
   wherein each one of the plurality of cells has an associated set of geometric parameters that are dependent upon the disposition of the cell in relation to the common inlet and the common outlet to produce a non-uniform lattice structure.

2. **The** cold plate of claim 1, in which the non-uniform lattice structure is configured to spatially vary the flow resistance of the coolant flow channels, thereby directing coolant and encouraging cold plate temperature uniformity.

3. The cold plate of claim 1 or claim 2, in which the set of geometric parameters comprise cell aspect ratio and cell wall thickness.

4. The cold plate of claim 3, in which the cell aspect ratio is from 1 to 1.4 and the cell wall thickness is from 0.3 to 4 millimetres.

5. The cold plate of any preceding claim, in which the triply periodic minimal surface is a gyroid.

6. The cold plate of any preceding claim, in which the cold plate has a polygonal base and a plurality of sides, and the common inlet and the common outlet are located on a common one of the plurality of sides of the cold plate.

7. The cold plate of any preceding claim, in which the cold plate comprises an aluminium alloy.

8. The cold plate of any preceding claim, in which the cold plate is formed by an additive manufacturing process or a vacuum investment casting process.

9. An arrangement comprising a device and a cold plate according to any preceding claim for transferring heat from a device to a liquid coolant.

10. The arrangement of claim 9, in which the device comprises a plurality of electrical power conversion devices.

**11.** A computer-implemented method of designing a cold plate for transferring heat from a device to a coolant, comprising:

obtaining the heat source characteristics of the device;

initialising a cold plate geometry, the cold plate geometry comprising a plurality of coolant flow channels extending from a common inlet to a common outlet, wherein the plurality of coolant flow channels is defined by a triply periodic minimal surface comprising a plurality of cells, and wherein each one of the plurality of cells has an associated set of geometric parameters that are dependent upon the disposition of the cell in relation to the common inlet and the common outlet;

establishing one or more control points within the cold plate geometry, wherein each one of the set of geometric parameters of the plurality of cells is controlled by one of a plurality of control points;

evaluating the heat transfer and total pressure loss characteristics of the cold plate geometry based on the heat source characteristics of the device;

performing one or more optimisation loops comprising adjusting the one or more control points to produce an adjusted cold plate geometry, and evaluating the heat transfer and total pressure loss characteristics of the adjusted cold plate geometry.

**12.** The method of claim 11, in which the control points are comprised within a radial basis function.

**13.** The method of claim 11 in which the control points are adjusted by performing a perturbation of the radial basis function at one or more of its control points.

**14.** The method of claim 11, in which the heat transfer and total pressure loss characteristics of the cold plate geometry are evaluated using a conjugate heat transfer simulation.

**15.** The method of claim 11, in which the optimisation loops are performed until no further change in heat transfer and total pressure loss characteristics is achieved.

FIG. 1

FIG. 2

FIG. 3A

FIG. 3B

EP 4 675 672 A1

FIG. 4B

FIG. 4A

FIG. 5

STATIC
TEMPERATURE

390 K

333 K

## FIG. 6A

STATIC
TEMPERATURE

390 K

333 K

## FIG. 6B

STATIC
TEMPERATURE

390 K

333 K

## FIG. 6C

Europäisches
Patentamt
European
Patent Office
Office européen
des brevets

# EUROPEAN SEARCH REPORT

**Application Number**

EP 25 18 2879

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2023/211461 A1 (HEWLETT PACKARD DEVELOPMENT CO [US]) 2 November 2023 (2023-11-02) * paragraphs [0001], [0011] - [0069]; figures 1-9 * | 1-15 | INV. H01L21/48 H01L23/367 H01L23/473 H01L23/373 |
| X | US 2020/333088 A1 (MANZO JOSEPH T [US]) 22 October 2020 (2020-10-22) * paragraphs [0002] - [0113]; figures 1-18 * | 1-15 | |
| X | US 2023/304743 A1 (BECENE AHMET T [US] ET AL) 28 September 2023 (2023-09-28) * paragraphs [0003] - [0044]; figures 1-3 * | 1-15 | |
| X | EP 4 180 151 A1 (RICOH CO LTD [JP]) 17 May 2023 (2023-05-17) * the whole document * | 1-15 | |

**TECHNICAL FIELDS SEARCHED (IPC)**

H01L

The present search report has been drawn up for all claims

| Place of search | Date of completion of the search | Examiner |
|---|---|---|
| The Hague | 16 November 2025 | Saynova, Desislava |

EPO FORM 1503 03.82 (P04C01)

**EP 4 675 672 A1**

## ANNEX TO THE EUROPEAN SEARCH REPORT
## ON EUROPEAN PATENT APPLICATION NO.

EP 25 18 2879

This annex lists the patent family members relating to the patent documents cited in the above-mentioned European search report.
The members are as contained in the European Patent Office EDP file on
The European Patent Office is in no way liable for these particulars which are merely given for the purpose of information.

16-11-2025

| Patent document cited in search report | Publication date | Patent family member(s) | Publication date |
|---|---|---|---|
| WO 2023211461 A1 | 02-11-2023 | WO 2023211461 A1 | 02-11-2023 |
| | | WO 2023211491 A1 | 02-11-2023 |
| US 2020333088 A1 | 22-10-2020 | US 2018187984 A1 | 05-07-2018 |
| | | US 2020333088 A1 | 22-10-2020 |
| US 2023304743 A1 | 28-09-2023 | EP 4253899 A1 | 04-10-2023 |
| | | US 2023304743 A1 | 28-09-2023 |
| EP 4180151 A1 | 17-05-2023 | CN 116123917 A | 16-05-2023 |
| | | EP 4180151 A1 | 17-05-2023 |
| | | JP 7563529 B2 | 08-10-2024 |
| | | JP 2023123485 A | 05-09-2023 |
| | | US 2023156969 A1 | 18-05-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2409059 A